# EUROPÄISCHE PATENTSCHRIFT

(11) **EP 3 785 035 B1**
(45) Veröffentlichungstag und Bekanntmachung des Hinweises auf die Patenterteilung: **09.03.2022**
(21) Anmeldenummer: 19710589.3
(22) Anmeldetag: 21.01.2019
(51) Int. Cl.: G01R 1/04, G01R 31/42

(54) **LEISTUNGSELEKTRONIKEINHEIT MIT INTEGRIERTEM STROMSENSOR ZUR AUSBILDUNG EINES MODULS; SOWIE ANTRIEBSSTRANG**
POWER ELECTRONICS UNIT HAVING INTEGRATED CURRENT SENSOR FOR FORMING A MODULE; AND DRIVE TRAIN
UNITÉ ÉLECTRONIQUE DE PUISSANCE COMPRENANT UN CAPTEUR DE COURANT INTÉGRÉ POUR LA FORMATION D'UN MODULE; AINSI QUE GROUPE MOTOPROPULSEUR

(30) Priorität: 24.04.2018 DE 102018109803
(43) Veröffentlichungstag der Anmeldung: 03.03.2021
(73) Patentinhaber: Schaeffler Technologies AG & Co. KG, 91074 Herzogenaurach (DE)
(72) Erfinder: TANG, Linbo, 76532 Baden-Baden (DE); BENDER, Marco, 77887 Sasbachwalden (DE); KÄSTLE, Matthias, 77886 Lauf (DE); BISKUP, Jan-Ulrich, 77833 Ottersweier (DE)
(86) Internationale Anmeldenummer: PCT/DE2019/100053
(87) Internationale Veröffentlichungsnummer: WO 2019/206357

(56) Entgegenhaltungen:
- CN-B- 102 761 287
- GB-A- 2 305 028
- US-A1- 2006 052 914
- US-A1- 2011 058 391
- US-A1- 2014 160 823
- US-A1- 2016 014 916
- Bernhard Eichler: "Optimieren durch Integrieren - Integrierte Shunt-Widerstände in Leistungsmodulen", , 1. September 2016 (2016-09-01), Seiten 70-71, XP055588839, Gefunden im Internet: URL:https://www.semikron.com/dl/service-su pport/downloads/download/semikron-facharti kel-optimieren-durch-integrieren-2016-10-1 4 [gefunden am 2019-05-15]
- Johannes Krupp: "No Need for External Sensors in New Inverters", , 1. Mai 2016 (2016-05-01), Seiten 24-30, XP055588835, Gefunden im Internet: URL:https://www.semikron.com/dl/service-su pport/downloads/download/semikron-article- no-need-for-external-sensors-en-2016-05-01 [gefunden am 2019-05-15]

## Beschreibung

Die Erfindung betrifft eine Leistungselektronikeinheit für einen elektrischen Antrieb, bspw. einen voll- oder teilelektrischen Antriebsstrang eines Kraftfahrzeuges, mit einem elektrisch leitfähigen Trägerelement und einem auf dem Trägerelement angeordneten Leistungshalbleitermodul, wobei das Leistungshalbleitermodul ausgebildet ist, einen Gleichstrom in einen dreiphasigen Wechselstrom umzuwandeln. Des Weiteren betrifft die Erfindung einen Antriebsstrang mit einem Elektromotor und der elektrisch mit diesem Elektromotor verbundenen Leistungselektronikeinheit.

Gattungsgemäßer Stand der Technik ist bspw. aus der KR 20150141404 A bekannt, mit der eine prinzipielle Leistungselektronik offenbart ist.

Somit ist bereits eine Leistungselektronik bekannt, die einen Gleichstrom (DC-Strom) aus einer Batterie in einen dreiphasigen Wechselstrom (AC-Strom) für einen Elektromotor umwandelt. Zur Umwandlung sind etwa Leistungshalbleitermodule eingesetzt.

Als nachteilig hat es sich bei den aus dem Stand der Technik bekannten Ausführungen jedoch herausgestellt, dass die bekannten Leistungselektronikeinheiten häufig relativ aufwändig aufgebaut sind. Insbesondere, wenn zusätzlich ein Strom zu messen ist, werden die Stromsensoren als separate Bauteileinheiten zumeist hinter dem Leistungshalbleitermodul verschaltet. Dadurch wird relativ viel Bauraum beansprucht und der Herstellaufwand ist relativ hoch.

Aus jeder der US 2014/160823 A1, der US 2006/052914 A1, der US 2011/058391 A1, der CN 102 761 287 B, der GB 2 305 028 A und der US 2016/014916 A1 ist eine Leistungselektronikeinheit gemäß dem Oberbegriff des Anspruchs 1 bekannt.

Weiterhin ist eine Leistungselektronikeinheit gemäß dem Oberbegriff des Anspruchs 1 aus Bernhard Eichler: "Optimieren durch Integrieren - integrierte Shunt-Widerstände in Leistungsmodulen", 1. September 2016 (2016-09-01), Seiten 70-71, XP055588839 und Johannes Krupp: "No Need for External Sensors in New Inverters", 1. Mai 2016 (2016-O5-01), Seiten 24-30, XP055588835 bekannt.

Es ist daher Aufgabe der vorliegenden Erfindung, die aus dem Stand der Technik bekannten Nachteile zu beheben und insbesondere eine Leistungselektronikeinheit zur Verfügung zu stellen, die einerseits eine verlässliche Strommessung zulässt, andererseits möglichst kompakt ausgebildet ist.

Dies wird erfindungsgemäß dadurch gelöst, dass ein zum Bestimmen des Wechselstroms (in seiner Größe) eingesetzter Stromsensor so integriert ist, dass er mit dem Trägerelement und dem Leistungshalbleitermodul ein (gemeinsames) Hauptmodul ausbildet.

Das Leistungshalbleitermodul ist somit gemeinsam mit dem Stromsensor wiederum modulartig zusammengesetzt. Dadurch wird eine besonders kompakte Bauweise der Kombination aus Leistungshalbleitermodul und Stromsensor ermöglicht. Der Aufbau ist einerseits möglichst kompakt, andererseits möglichst einfach herstellbar.

Weitere vorteilhafte Ausführungen sind mit den Unteransprüchen beansprucht und nachfolgend näher erläutert.

Demnach ist es zudem vorteilhaft, wenn der Stromsensor mit einem Leistungshalbleiter des Leistungshableitermoduls elektrisch verbunden ist. Dadurch wird der Aufbau noch kompakter.

Ist der Stromsensor direkt mit dem Trägerelement mechanisch verbunden, lässt sich der Aufbau weiter vereinfachen.

In diesem Zusammenhang ist es auch zweckmäßig, wenn der Stromsensor direkt auf dem Trägerelement appliziert ist. Dadurch ergibt sich eine Integration des Stromsensors auf Chip-Ebene. Der Herstellaufwand wird weiter reduziert.

Alternativ zu der direkten Anbringung des Stromsensors an dem Trägerelement ist es auch von Vorteil, wenn der Stromsensor indirekt mit dem Leistungshalbleitermodul und/oder dem Trägerelement mechanisch verbunden ist. Dadurch wird der Herstellaufwand weiter erleichtert.

In diesem Zusammenhang ist es des Weiteren zweckmäßig, wenn der Stromsensor auf einer Stromschiene angebracht ist und die Stromschiene weiter mit dem Trägerelement und/oder dem Leistungshalbleiter des Leistungshalbleitermoduls elektrisch und/oder mechanisch verbunden ist.

Ist der Stromsensor außerhalb oder innerhalb einer im Wesentlichen rechteckförmigen Außenkontur des Trägerelements oder teilweise überlappend mit dieser Außenkontur angeordnet, wird ein geeigneter Kompromiss zwischen einer kompakten Bauweise sowie einer leichten Herstellung umgesetzt.

Das Leistungshalbleitermodul ist weiter bevorzugt von einem Modulgehäuse umschlossen, sodass der Wirkungsgrad sowie die Lebensdauer der Leistungselektronikeinheit deutlich erweitert werden.

In diesem Zusammenhang ist es wiederum zweckmäßig, wenn der Stromsensor ebenfalls in dem Modulgehäuse mit angeordnet / integriert ist. Somit wird eine besonders kompakte Bauweise realisiert. Alternativ ist es auch vorteilhaft, den Stromsensor in einem separat zu dem Modulgehäuse ausgebildeten Sensorgehäuse (vorzugsweise außerhalb des Modulgehäuses) anzuordnen. Dadurch wird die Montage vereinfacht.

Das Leistungshalbleitermodul ist bevorzugt als ein IGBT-Modul, d. h. ein modulartiger Bipolartransistor mit isolierter Gate-Elektrode, realisiert. Dadurch ist der Aufbau besonders leistungsfähig.

Da das Trägerelement als Stanzgitter umgesetzt ist, wird der Herstellaufwand nochmals deutlich gesenkt.

Des Weiteren betrifft die Erfindung einen Antriebsstrang (vorzugsweise einen rein elektromotorisch / elektrischen, weiter bevorzugt einen hybriden Antriebsstrang) für ein Kraftfahrzeug, mit einer mit einem Elektromotor elektrisch verbundenen Leistungselektronikeinheit nach zumindest einer der zuvor beschriebenen Ausführungen. Die Leistungselektronikeinheit ist zudem mit einer Batterie vorzugsweise elektrisch verbunden. Die Leistungselektronikeinheit ist somit prinzipiell für den Anwendungsbereich des Kraftfahrzeuges ausgebildet, kann in weiteren Ausführungen jedoch auch generell für andere Anwendungen ausgebildet sein, in denen die als entsprechender Wechselstrom-Umrichter ausgebildete Leistungselektronikeinheit einsetzbar ist.

In anderen Worten ausgedrückt, ist somit erfindungsgemäß ein Stromsensor in einem Leistungsmodul (Leistungselektronikeinheit) integriert. Der Stromsensor ist in dem Leistungshalbleitermodul durch eine Verbindungstechnik angebracht / integriert oder durch eine Integration auf einer Chip-Ebene angeordnet.

Die Erfindung wird nun nachfolgend anhand von Figuren in Verbindung mit verschiedenen Ausführungsbeispielen näher erläutert.

Es zeigen:

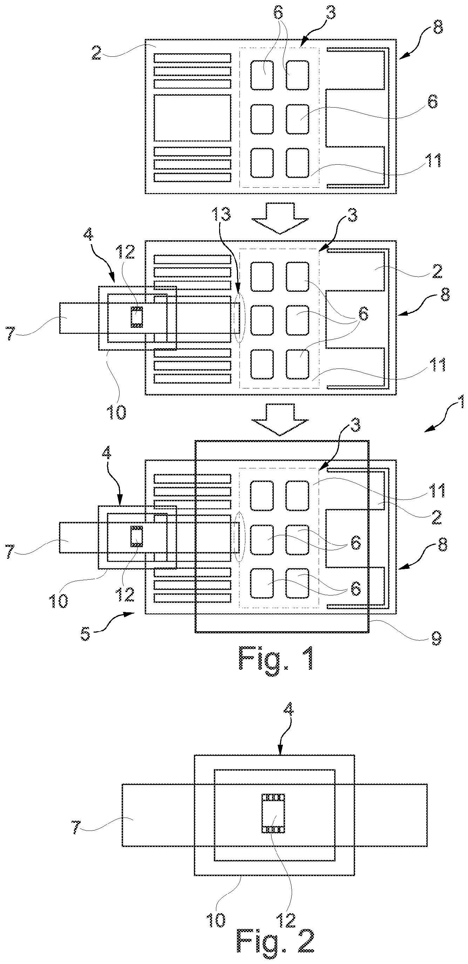

- Fig. 1: eine Draufsicht auf eine erfindungsgemäße Leistungselektronikeinheit nach einem ersten Ausführungsbeispiel in verschiedenen Zusammenbauzustän-den, wobei in der obersten Teildarstellung der Fig. 1 lediglich ein Leistungs-halbleitermodul auf einem Trägerelement aufgebracht ist, in der mittleren Teildarstellung der Fig. 1 zusätzlich ein Stromsensor über eine Stromschiene mit dem Leistungshalbleitermodul verbunden ist und in der unteren Teildar-stellung der Fig. 1 zusätzlich ein Modulgehäuse das Leistungshalbleitermo-dul umhaust,
- Fig. 2: eine Draufsicht auf den in der Fig. 1 eingesetzten Zusammenbau aus einem Stromsensor und einer Stromschiene,

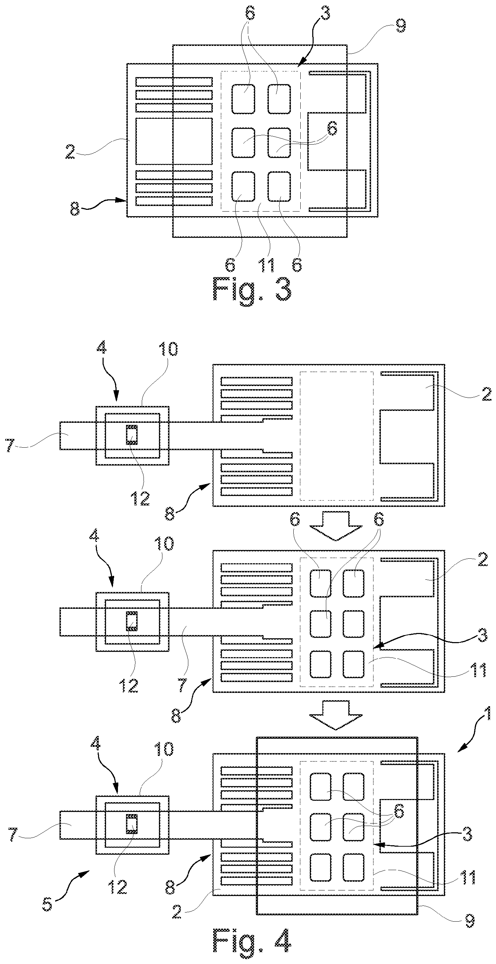

- Fig. 3: eine Draufsicht auf einen Zusammenbau aus dem Trägerelement, dem Leis-tungshalbleitermodul und dem Modulgehäuse, wie sie in Fig. 1 eingesetzt sind,
- Fig. 4: eine Draufsicht auf eine erfindungsgemäße Leistungselektronikeinheit nach einem zweiten Ausführungsbeispiel in verschiedenen Zusammenbauzustän-den, wobei in der oberen Teildarstellung der Fig. 4 lediglich der Stromsensor über die Stromschiene mit dem Trägerelement verbunden ist, in der mittleren Teildarstellung der Fig. 4 zusätzlich das Leistungshalbleitermodul an dem Trägerelement angebracht ist und in der unteren Teildarstellung der Fig. 4 zusätzlich das Modulgehäuse vorhanden ist, und

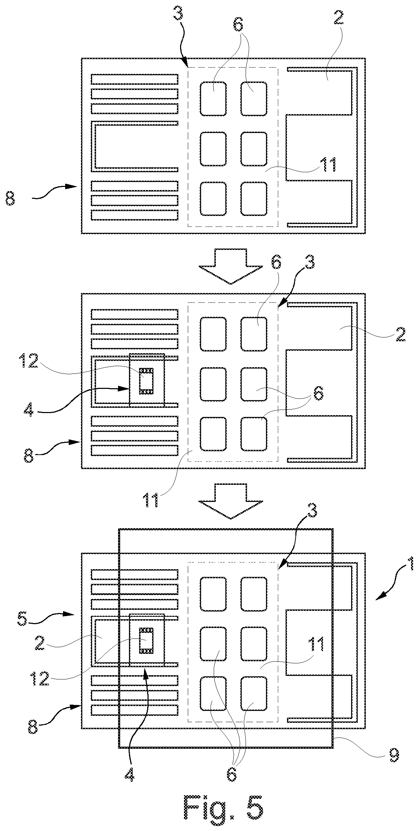

- Fig. 5: eine Draufsicht auf eine erfindungsgemäße Leistungselektronikeinheit nach einem dritten Ausführungsbeispiel in verschiedenen Zusammenbauzustän-den, wobei in der oberen Teildarstellung der Fig. 5 das Leistungselektronik-modul lediglich an dem Trägerelement vorhanden ist, in der mittleren Teildar-stellung der Fig. 5 der Stromsensor weiterhin direkt an dem Trägerelement aufgebracht ist und in der unteren Teildarstellung der Fig. 4 das Modulge-häuse sowohl um das Leistungshalbleitermodul als auch um den Stromsensor herum angebracht ist.

Die Figuren sind lediglich schematischer Natur und dienen ausschließlich dem Verständnis der Erfindung. Die gleichen Elemente sind mit denselben Bezugszeichen versehen. Auch können die verschiedenen Merkmale der unterschiedlichen Ausführungsbeispiele frei miteinander kombiniert werden.

Eine erfindungsgemäße Leistungselektronikeinheit 1 ist gemäß einem ersten Ausführungsbeispiel in Fig. 1 veranschaulicht. Die Leistungselektronikeinheit 1 ist in Fig. 1 in unterschiedlichen Zusammenbauzuständen veranschaulicht, wobei die unterste Teildarstellung die im Wesentlichen vollständige Leistungselektronikeinheit 1 zeigt. Die als Wechselstrom-Umrichter ausgebildete Leistungselektronikeinheit 1 dient im Betrieb auf typische Weise zum Wandeln eines eingangsseitig durch eine Batterie vorgegebenen Gleichstromes in einen ausgangsseitig zum Antrieb eines Elektromotors eines Kraftfahrzeugantriebsstranges verwendeten Wechselstromes.

Die Leistungselektronikeinheit 1 weist ein elektrisch leitfähiges Trägerelement 2, das in dieser Ausführung in Form eines Stanzgitters realisiert ist, auf. Das Trägerelement 2 nimmt des Weiteren ein Leistungshalbleitermodul 3 auf. Das Leistungshalbleitermodul 3 weist auf typische Weise mehrere Leistungshalbleiter 6 auf, die auf einem Substrat 11, hier einem Keramiksubstrat, eingebettet sind. Das Leistungshalbleitermodul 3 ist an dem Trägerelement 2 mechanisch befestigt und mit seinen Leistungshalbleitern 6 elektrisch über verschiedene hier der Übersichtlichkeit halber nicht weiter dargestellte Leitungsbahnen mit einem Stromeingang sowie einem Stromausgang verbunden. Das Leistungshalbleitermodul 3 ist als ein IGBT-Modul realisiert. Der Vorzusammenbau des Trägerelements 2 mit dem Leistungshalbleitermodul 3 ist in der obersten Teildarstellung der Fig. 1 gut zu erkennen.

Die Leistungselektronikeinheit 1 weist erfindungsgemäß, wie dann in der mittleren Teildarstellung der Fig. 1 veranschaulicht, 4 unmittelbar einen Stromsensor 4 mit auf. Der Stromsensor 4 ist direkt in der Leistungselektronikeinheit 1 integriert. Insbesondere bildet der Stromsensor 4 mit dem Trägerelement 2 und dem Leistungshalbleitermodul 3 ein gemeinsames Hauptmodul 5 / Elektronikmodul aus. Somit sind Stromsensor 4, Trägerelement 2 und Leistungshalbleitermodul 3 in einem Baukasten integriert.

In dieser Ausführung ist der Stromsensor 4 indirekt an dem Trägerelement 2 sowie dem Leistungshalbleitermodul 3 mechanisch angebracht. Der Stromsensor 4 ist hierzu, wie in Fig. 2 gut zu erkennen, auf einer Stromschiene 7 befestigt. Hierzu ist ein, ein Chip 12 aufweisender Bereich des Stromsensors 4 unmittelbar auf der Stromschiene 7 elektrisch sowie mechanisch angebracht / befestigt. Den Stromsensor 4 umgibt ein Sensorgehäuse 10 von außen, sodass der Stromsensor 4 durch das Sensorgehäuse 10 zur Umgebung hin abgeschlossen ist. Wie des Weiteren in der mittleren Teildarstellung der Fig. 1 angedeutet, ist die Stromschiene 7 direkt an dem Leistungshalbleitermodul 3, nämlich einem Leistungshalbleiter 6 elektrisch angeschlossen.

Hierzu dient auf typische Weise eine übliche Verbindungsart, wie eine Verschweißung, eine Verlötung oder sonstige ähnliche Verbindungsarten. Auch ist die Stromschiene 7 bevorzugt an dem Trägerelement 2 befestigt.

In dem fertigen Montagezustand der Leistungselektronikeinheit 1, die in der untersten Teildarstellung der Fig. 1 veranschaulicht ist, ist das Leistungshalbleitermodul 3 zusätzlich von einem Modulgehäuse 9 umhaust. Dieses Modulgehäuse 9 ist beabstandet zu dem Sensorgehäuse 10 angeordnet, d. h. dass das Sensorgehäuse 10 außerhalb des Modulgehäuses 9 angeordnet ist. Das Modulgehäuse 9 nimmt die Leistungshalbleiter 6 des Leistungshalbleitermoduls 3 vollständig auf. Insbesondere ist auch eine (mechanische sowie elektrische) Verbindungsstelle 13 zwischen der Stromschiene 7 und dem Leistungshalbleiter 6 / dem Leistungshalbleitermodul 3 von dem Modulgehäuse 9 mit umschlossen. Das Modulgehäuse 9 ist zusammen mit dem Leistungshalbleitermodul 3 und dem Trägerelement 2 ohne Stromsensor 4 in Fig. 3 dargestellt.

Hinsichtlich der Ausformung des Trägerelements 2 ist in Fig. 1 auch zu erkennen, dass dieses von oben betrachtet, d. h. in einer Ebene betrachtet, im Wesentlichen rechteckförmig ist. Das Trägerelement 2 weist somit eine rechteckförmige Außenkontur 8 auf. Der Stromsensor 4 ist in dieser Ausführung teilweise überlappend zu dieser Außenkontur 8 angeordnet. Insbesondere ragt die Stromschiene 7 von einer Außenseite aus zu einer Innenseite der Außenkontur 8 hin zu dem Leistungshalbleitermodul 3 über die Außenkontur 8 hinüber.

Gemäß dem mit den Teildarstellungen der Fig. 1 veranschaulichten Montagevorgang wird zunächst, in einem ersten Schritt, das Leistungshalbleitermodul 3 am Trägerelement 2 befestigt (obere Teildarstellung der Fig. 1). In einem weiteren Schritt wird die Stromschiene 7 samt dem Stromsensor 4 am Trägerelement 2 befestigt und mit dem Leistungshalbleitermodul 3 elektrisch sowie mechanisch verbunden (mittlere Teildarstellung der Fig. 1). Gemäß der unteren Teildarstellung der Fig. 1 wird schließlich in einem weiteren Schritt das Modulgehäuse 9 angebracht.

In Verbindung mit den Fign. 4 und 5 sind weitere Ausführungsbeispiele der erfindungsgemäßen Leistungselektronikeinheit 1 veranschaulicht, wozu der Kürze wegen lediglich die Unterschiede zu dem ersten Ausführungsbeispiel nachfolgend beschrieben sind. Die Leistungselektronikeinheiten 1 der Fign. 4 und 5 entsprechen in Funktion und Aufbau prinzipiell der Leistungselektronikeinheit 1 des ersten Ausführungsbeispiels.

In Verbindung mit Fig. 4 ist das zweite Ausführungsbeispiel gezeigt. Hierbei ist die Stromschiene 7 in ihrer Länge so gewählt und der Stromsensor 4 derart auf der Stromschiene 7 angeordnet, dass der Stromsensor 4 mit seinem Sensorgehäuse 10 außerhalb der Außenkontur 8, in Bezug auf das Leistungshalbleitermodul 3, angeordnet ist.

Gemäß dem mit den Teildarstellungen der Fig. 4 veranschaulichten Montagevorgang wird die Stromschiene 7 samt dem Stromsensor 4 vor einem Anbringen des Leistungshalbleitermoduls 3 am Trägerelement 2 bereits am Trägerelement 2 befestigt (obere Teildarstellung der Fig. 4). Nachdem die Stromschiene 7 mechanisch und elektrisch an dem Trägerelement 2 angebracht ist, wird das Leistungshalbleitermodul 3, wie bereits in Fig. 1, an dem Trägerelement 2 befestigt und mit der Stromschiene 7 verbunden (mittlere Teildarstellung der Fig. 4). In der unteren Teildarstellung der Fig. 4 ist das Modulgehäuse 9 entsprechend dem ersten Ausführungsbeispiel wiederum angebracht.

In diesem Zusammenhang sei darauf hingewiesen, dass die Stromschiene 7 und das Trägerelement 2 in einer weiteren Ausführung unmittelbar ein einziges Bauteil bilden, das speziell an das Leistungshalbleitermodul 3 angepasst ist. Somit spart man den Prozessschritt der mechanischen Anbringung der Stromschiene 7 an dem Trägerelement 2.

In Fig. 5 ist schließlich das dritte Ausführungsbeispiel veranschaulicht, was erkennen lässt, dass der Stromsensor 4 prinzipiell unmittelbar / direkt an dem Trägerelement 2 angebracht ist. In dieser Ausführung ist der Stromsensor 4 mit seinem Chip 12 unmittelbar auf dem Trägerelement 2 appliziert. Der Stromsensor 4 ist somit direkt mechanisch sowie elektrisch mit dem Trägerelement 2 verbunden sowie indirekt elektrisch mit dem Leistungshalbleiter 6 des Leistungshalbleitermoduls 3 verbunden. In dieser Ausführung ist auf ein Sensorgehäuse 10 verzichtet, da der Stromsensor 4 gemeinsam mit dem Leistungshalbleitermodul 3 in dem Modulgehäuse 9 integriert ist. Somit sind Stromsensor 4 und Leistungshalbleitermodul 3 von einem gemeinsamen Modulgehäuse 9 umschlossen (untere Teildarstellung der Fig. 5). Der Stromsensor 4 ist innerhalb der Außenkontur 8 angeordnet.

Gemäß dem mit den Teildarstellungen der Fig. 5 veranschaulichten Montagevorgang wird zunächst, in einem ersten Schritt, das Leistungshalbleitermodul 3 am Trägerelement 2 befestigt (obere Teildarstellung der Fig. 5). In einem weiteren Schritt wird der Stromsensor 4 direkt am Trägerelement 2 befestigt und mit dem Leistungshalbleitermodul 3 elektrisch verbunden (mittlere Teildarstellung der Fig. 5). Gemäß der unteren Teildarstellung der Fig. 5 wird schließlich in einem weiteren Schritt das Modulgehäuse 9 angebracht.

In anderen Worten ausgedrückt, wird erfindungsgemäß der Stromsensor 4 durch Verbindungstechnik bzw. Integration auf Chip-Ebene mit dem Leistungshalbleitermodul 3 zu einer Einheit 5 appliziert. Dabei können prinzipiell folgende drei Varianten I, II, II umgesetzt werden.

Variante I (Fig. 1): Verbindung zwischen dem Stanzgitter (Trägerelement 2) und Stromschiene 7 des Stromsensors 4 innerhalb des Leistungshalbleitermoduls (Leistungshalbleitereinheit 1). Der Leistungshalbleiter (Leistungshalbleitermodul 3) wird inklusive Stanzgitter 2 als eine Einheit hergestellt. Der Stromsensor 4 wird inklusive Stromschiene 7 zu Leistungshalbleiter 3 geführt und direkt mit dem Leistungshalbleiter 3 elektrisch und mechanisch verbunden, z.B. durch Verschweißung oder durch Lötprozesse. Ein Gehäuse (Modulgehäuse 9) wird zum Schluss um den Leistungshalbleiter 3 und Bereiche des Stanzgitters 2 appliziert, um die Leistungshalbleiter 6 zu schützen.

Variante II (Fig. 4): Stromsensor 4 inklusive Stromschiene 7 und Stanzgitter 2. Der Stromsensor 4 wird auf einem Stanzgitter 2 mit einer erweiterten Stromschiene 7 verbaut. Der Leistungshalbleiter 3 wird z.B. durch Lötprozesse, Schweißen oder durch ähnlichen Verbindungstechniken mit dem Stanzgitter 2 verbunden. Anschließend wird ein Gehäuse 9 um den Leistungshalbleiter 3 und Bereiche des Stanzgitters 2 appliziert, um die Leistungshalbleiter 6 zu schützen.

Variante III (Fig. 5): Integrierter Stromsensor 4 im Leistungshalbleitermodul (Leistungshalbleitereinheit 1). Die Leistungshalbleiter 6 werden inklusive Stanzgitter 2 als eine Einheit hergestellt. Der Stromsensor 4 soll ohne Gehäuse (Sensorgehäuse 10) auf der Stromschiene 7 des Stanzgitters 2 appliziert werden. Ein Gehäuse 9 wird um den Leistungshalbleiter 3, Bereiche des Stanzgitters 2 und den Stromsensor 4 appliziert.

### Bezugszeichenliste

- 1: Leistungselektronikeinheit
- 2: Trägerelement
- 3: Leistungshalbleitermodul
- 4: Stromsensor
- 5: Hauptmodul
- 6: Leistungshalbleiter
- 7: Stromschiene
- 8: Außenkontur
- 9: Modulgehäuse
- 10: Sensorgehäuse
- 11: Substrat
- 12: Chip
- 13: Verbindungsstelle

## Patentansprüche

1. Leistungselektronikeinheit (1) für einen elektrischen Antrieb, wobei die Leistungselektronikeinheit (1) aufweist:
ein elektrisch leitfähiges Trägerelement (2),
ein auf dem Trägerelement (2) angeordnetes Leistungshalbleitermodul (3), das ausgebildet ist, einen Gleichstrom in einen dreiphasigen Wechselstrom umzuwandeln, und
einen zum Bestimmen des Wechselstroms eingesetzten Stromsensor (4), der so integriert ist, dass er mit dem Trägerelement (2) und dem Leistungshalbleitermodul (3) ein Hauptmodul (5) ausbildet,
**dadurch gekennzeichnet, dass**
das Trägerelement (2) als Stanzgitter umgesetzt ist.

2. Leistungselektronikeinheit (1) nach Anspruch 1, **dadurch gekennzeichnet, dass** der Stromsensor (4) und/oder eine den Stromsensor (4) aufnehmende Stromschiene (7) mit einem Leistungshalbleiter (6) des Leistungshalbleitermoduls (3) elektrisch verbunden ist.

3. Leistungselektronikeinheit (1) nach Anspruch 1 oder 2, **dadurch gekennzeichnet, dass** der Stromsensor (4) direkt mit dem Trägerelement (2) mechanisch verbunden ist.

4. Leistungselektronikeinheit (1) nach einem der Ansprüche 1 bis 3, **dadurch gekennzeichnet, dass** der Stromsensor (4) direkt auf dem Trägerelement (2) appliziert ist.

5. Leistungselektronikeinheit (1) nach Anspruch 1 oder 2, **dadurch gekennzeichnet, dass** der Stromsensor (4) indirekt mit dem Leistungshalbleitermodul (3) und/oder dem Trägerelement (2) mechanisch verbunden ist.

6. Leistungselektronikeinheit (1) nach Anspruch 5, **dadurch gekennzeichnet, dass** der Stromsensor (4) auf einer Stromschiene (7) angebracht ist und die Stromschiene (7) weiter mit dem Trägerelement (2) und/oder dem Leistungshalbleiter (6) des Leistungshalbleitermoduls (3) elektrisch und mechanisch verbunden ist.

7. Leistungselektronikeinheit (1) nach einem der Ansprüche 1 bis 6, **dadurch gekennzeichnet, dass** der Stromsensor (4) außerhalb oder innerhalb einer im Wesentlichen rechteckförmigen Außenkontur (8) des Trägerelements (2) oder teilweise überlappend mit dieser Außenkontur (8) angeordnet ist.

8. Leistungselektronikeinheit (1) nach einem der Ansprüche 1 bis 7, **dadurch gekennzeichnet, dass** das Leistungshalbleitermodul (3) von einem Modulgehäuse (9) umschlossen ist.

9. Leistungselektronikeinheit (1) nach Anspruch 8, **dadurch gekennzeichnet, dass** der Stromsensor (4) in dem Modulgehäuse (9) mit oder in einem separat zu dem Modulgehäuse (9) ausgebildeten Sensorgehäuse (10) angeordnet ist.

10. Antriebsstrang für ein Kraftfahrzeug, mit einer mit einem Elektromotor elektrisch verbundenen Leistungselektronikeinheit (1) nach einem der Ansprüche 1 bis 9.

## Claims

1. A power electronics unit (1) for an electric drive train, wherein the power electronics unit (1) has:
an electrically conductive carrier element (2),
a power semiconductor module (3), which is arranged on the carrier element (2) and is designed to convert a direct current into a three-phase alternating current, and
a current sensor (4) used to determine the alternating current, which is integrated in such a way that it forms a main module (5) with the carrier element (2) and the power semiconductor module (3),
**characterised in that**
the carrier element (2) is implemented as a lead frame.

2. The power electronics unit (1) according to claim 1, **characterised in that** the current sensor (4) and/or a busbar (7) receiving the current sensor (4) is electrically connected to a power semiconductor (6) of the power semiconductor module (3).

3. The power electronics unit (1) according to claim 1 or 2, **characterised in that** the current sensor (4) is directly mechanically connected to the carrier element (2).

4. The power electronics unit (1) according to one of claims 1 to 3, **characterised in that** the current sensor (4) is applied directly to the carrier element (2).

5. The power electronics unit (1) according to claim 1 or 2, **characterised in that** the current sensor (4) is indirectly mechanically connected to the power semiconductor module (3) and/or the carrier element (2).

6. The power electronics unit (1) according to claim 5, **characterised in that** the current sensor (4) is mounted on a busbar (7) and the busbar (7) is further electrically and mechanically connected to the carrier element (2) and/or the power semiconductor (6) of the power semiconductor module (3).

7. The power electronics unit (1) according to one of claims 1 to 6, **characterised in that** the current sensor (4) is arranged outside or inside a substantially rectangular outer contour (8) of the carrier element (2) or partially overlapping this outer contour (8).

8. The power electronics unit (1) according to one of claims 1 to 7, **characterised in that** the power semiconductor module (3) is enclosed in a module housing (9).

9. The power electronics unit (1) according to claim 8, **characterised in that** the current sensor (4) is arranged in the module housing (9) with or in a sensor housing (10) formed separately from the module housing (9).

10. A drive train for a motor vehicle, having a power electronics unit (1) according to one of claims 1 to 9 which is electrically connected to an electric motor.

## Revendications

1. Unité électronique de puissance (1) pour un entraînement électrique, l'unité électronique de puissance (1) présentant :
un élément de support (2) électriquement conducteur,
un module semi-conducteur de puissance (3) disposé sur l'élément de support (2), qui est conçu pour convertir un courant continu en un courant alternatif triphasé et
un capteur de courant (4) servant à déterminer le courant alternatif, intégré de manière à former, avec l'élément de support (2) et le module semi-conducteur de puissance (3), un module principal (5),
**caractérisée en ce que**
l'élément de support (2) est formé comme une grille estampée.

2. Unité électronique de puissance (1) selon la revendication 1, **caractérisée en ce que** le capteur de courant (4) et/ou un rail conducteur (7) recevant le capteur de courant (4) sont reliés électriquement à un semi-conducteur de puissance (6) du module semi-conducteur de puissance (3).

3. Unité électronique de puissance (1) selon la revendication 1 ou 2, **caractérisée en ce que** le capteur de courant (4) est relié mécaniquement directement à l'élément de support (2).

4. Unité électronique de puissance (1) selon l'une quelconque des revendications 1 à 3, **caractérisée en ce que** le capteur de courant (4) est appliqué directement sur l'élément de support (2).

5. Unité électronique de puissance (1) selon la revendication 1 ou 2, **caractérisée en ce que** le capteur de courant (4) est relié mécaniquement indirectement au module semi-conducteur de puissance (3) et/ou à l'élément de support (2).

6. Unité électronique de puissance (1) selon la revendication 5, **caractérisée en ce que** le capteur de courant (4) est posé sur un rail conducteur (7) et le rail conducteur (7) est en outre relié électriquement et mécaniquement à l'élément de support (2) et/ou au semi-conducteur de puissance (6) du module semi-conducteur de puissance (3).

7. Unité électronique de puissance (1) selon l'une quelconque des revendications 1 à 6, **caractérisée en ce que** le capteur de courant (4) est agencé à l'extérieur ou à l'intérieur d'un contour externe (8) sensiblement rectangulaire de l'élément de support (2) ou en chevauchement partiel de ce contour externe (8).

8. Unité électronique de puissance (1) selon l'une quelconque des revendications 1 à 7, **caractérisée en ce que** le module semi-conducteur de puissance (3) est entouré d'un boîtier de module (9).

9. Unité électronique de puissance (1) selon la revendication 8, **caractérisée en ce que** le capteur de courant (4) est agencé dans le boîtier de module (9) avec ou dans un boîtier de capteur (10) conçu séparément du boîtier de module (9).

10. Groupe motopropulseur pour un véhicule à moteur, comprenant une unité électronique de puissance (1) selon l'une quelconque des revendications 1 à 9 qui est reliée électriquement à un moteur électrique.
